(19) Europäisches Patentamt / European Patent Office / Office européen des brevets

(11) **EP 3 843 161 B1**

(12) **FASCICULE DE BREVET EUROPEEN**

(45) Date de publication et mention de la délivrance du brevet:
**28.09.2022 Bulletin 2022/39**

(21) Numéro de dépôt: **20216147.7**

(22) Date de dépôt: **21.12.2020**

(51) Classification Internationale des Brevets (IPC):
**H01L 33/40** (2010.01)     *H01L 33/44* (2010.01)

(52) Classification Coopérative des Brevets (CPC):
**H01L 33/405;** H01L 33/02; H01L 33/44;
H01L 2933/0016; H01L 2933/0025

(54) **PROCEDE DE FABRICATION D'UNE DIODE ELECTROLUMINESCENTE COMPORTANT UNE ETAPE DE DIMENSIONNEMENT D'UNE COUCHE SEMICONDUCTRICE**

VERFAHREN ZUR HERSTELLUNG EINER LEUCHTDIODE, DAS EINEN DIMENSIONIERUNGSSCHRITT EINER HALBLEITERSCHICHT UMFASST

METHOD FOR MANUFACTURING A LIGHT-EMITTING DIODE COMPRISING A STEP OF SIZING OF A SEMICONDUCTOR LAYER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2019 FR 1915502**

(43) Date de publication de la demande:
**30.06.2021 Bulletin 2021/26**

(73) Titulaire: **Commissariat à l'Energie Atomique et aux Energies Alternatives**
**75015 Paris (FR)**

(72) Inventeurs:
• **LE BLEVENNEC, Gilles**
  **38054 GRENOBLE Cedex 09 (FR)**
• **BEN BAKIR, Badhise**
  **38054 GRENOBLE Cedex 09 (FR)**
• **SARELLI, Eirini**
  **38054 GRENOBLE Cedex 09 (FR)**

(74) Mandataire: **INNOV-GROUP**
**310, avenue Berthelot**
**69372 Lyon Cedex 08 (FR)**

(56) Documents cités:
EP-A1- 2 362 448     EP-A2- 1 855 327
US-A1- 2012 153 254     US-A1- 2014 008 676

**Description**

**DOMAINE TECHNIQUE**

Le domaine de l'invention est celui des procédés de fabrication des diodes électroluminescentes qui comportent une couche active située dans un empilement semiconducteur de couches inorganiques ou organiques.

**ÉTAT DE LA TECHNIQUE ANTÉRIEURE**

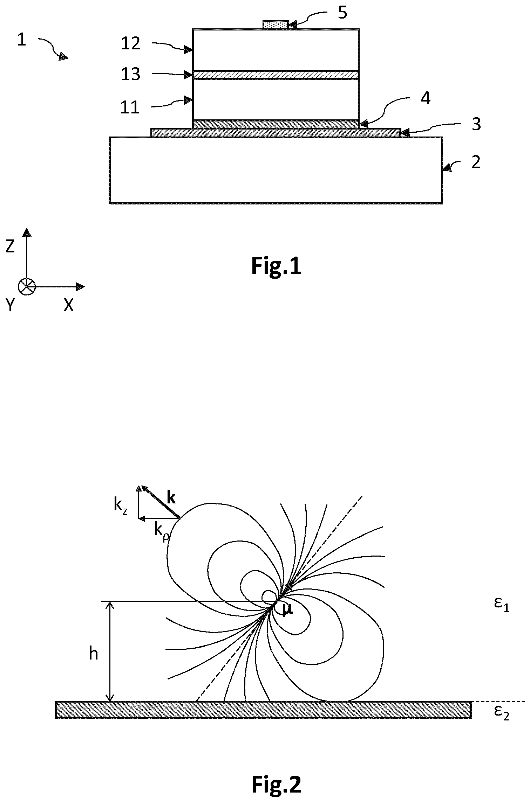

La figure 1 illustre de manière partielle et schématique un exemple d'une diode électroluminescente 1 comportant un empilement de couches semiconductrices, ici inorganiques, dont une première couche 11 dopée P, une deuxième couche 12 dopée N, et une couche active 13 disposée entre les deux couches dopées 11, 12 et au niveau de laquelle est émis l'essentiel du rayonnement lumineux.

La diode électroluminescente 1 repose ici sur un substrat 2 comportant une couche conductrice 3, au contact de laquelle se situe une électrode 4 avantageusement réflectrice formant l'anode. Une électrode 5 de préférence transparente formant une cathode repose sur la couche 12 dopée N. L'électrode réflectrice 4 est de préférence réalisée en un matériau métallique.

La couche active 13 peut être formée, dans le cas d'une jonction PN, par l'interface des deux couches dopées 11, 12 au contact l'une de l'autre, ou dans le cas d'une jonction PIN, par au moins une couche intrinsèque 13 (i.e. non intentionnellement dopée) pouvant comporter un ou plusieurs puits quantiques. Chaque puits quantique peut être formé par une couche présentant une énergie de bande interdite plus faible que celle des deux couches barrières entre lesquelles elle est située, ou peut être formé par des boîtes quantiques (*quantum dots,* en anglais).

Les porteurs de charge (électrons et trous) sont introduits dans l'empilement semiconducteur par les électrodes 4, 5, puis diffusent jusqu'à la couche active 13 où ils se recombinent de manière radiative. Le rayonnement lumineux associé aux recombinaisons radiatives des paires électron-trou dans la couche active 13 correspond au rayonnement dipolaire électrique émis par un dipôle dit émetteur qui oscille de manière harmonique suivant l'axe de son moment dipolaire $\mu$ (également appelé TDMV, pour *Transition Dipole Moment Vector,* en anglais).

La figure 2 illustre de manière schématique un dipôle émetteur situé dans un premier milieu (contenant la couche active) optiquement linéaire, homogène et isotrope, de constante diélectrique $\varepsilon_1$ (contenant la couche active) et espacé d'un deuxième milieu optiquement linéaire, homogène et isotrope, de constante diélectrique $\varepsilon_2$. Il présente ici une orientation inclinée d'un angle $\theta$ vis-à-vis de l'axe Z orthogonal au plan XY de la couche active. Les lignes de champ s'étendent suivant une symétrie axiale autour de l'axe du moment dipolaire $\mu$. Le vecteur d'onde **k** est orthogonal à la tangente en un point quelconque d'une ligne de champ. Comme l'indique l'article de Schmidt et al intitulé Emitter Orientation as a Key Parameter in Organic Light-Emitting Diodes, Phys. Rev. Applied 8,037001 (2017), l'orientation des dipôles émetteurs est un paramètre qui peut impacter le rendement lumineux d'une diode émissive telle qu'une diode électroluminescente organique.

Le document EP1855327A2 décrit une diode électroluminescente dont la distance entre la couche active et une couche réflectrice est déterminée de sorte que les dipôles émetteurs de la couche active présentent une orientation horizontale, améliorant ainsi le rendement lumineux. Les documents US2012/153254A1, EP2362448A1 et US2014/008676A1 divulguent d'autres diodes électroluminescentes de l'art antérieur.

Il existe ainsi un besoin de disposer d'un procédé de fabrication d'au moins une diode électroluminescente dont le rendement lumineux est davantage amélioré.

**EXPOSÉ DE L'INVENTION**

L'invention a pour objectif de remédier au moins en partie aux inconvénients de l'art antérieur, et plus particulièrement de proposer un procédé de fabrication d'au moins une diode électroluminescente présentant un rendement lumineux amélioré.

Pour cela, l'objet de l'invention est un procédé de fabrication d'au moins une diode électroluminescente comportant un empilement formé d'une première couche semiconductrice, d'une deuxième couche semiconductrice, et d'une couche active située entre les deux couches semiconductrices, une électrode réflectrice s'étendant au contact de la première couche semiconductrice. Le procédé comporte les étapes suivantes :

- choix des matériaux de la première couche semiconductrice et de la couche active, et de l'électrode réflectrice ;
- choix d'une orientation, vis-à-vis d'un plan de la couche active, des dipôles dits émetteurs associés aux recombinaisons radiatives de paires électron-trou dans la couche active, parmi : une orientation horizontale pour laquelle les dipôles émetteurs sont orientés de manière parallèle au plan de la couche active, et une orientation verticale pour laquelle les dipôles émetteurs sont orientés de manière orthogonale au plan de la couche active ;

- choix des matériaux de la deuxième couche semiconductrice, et d'un troisième milieu recouvrant la deuxième couche semiconductrice ;
- détermination d'une distance non nulle entre les dipôles émetteurs et ledit troisième milieu, pour laquelle une durée de vie des dipôles émetteurs présentant l'orientation choisie est supérieure à celle des dipôles émetteurs présentant l'orientation non choisie, à partir d'une fonction prédéterminée exprimant une évolution d'un paramètre représentatif de la durée de vie d'un dipôle émetteur présentant l'une ou l'autre desdites orientations en fonction de sa distance audit troisième milieu, compte tenu des propriétés optiques desdits matériaux choisis ;
- détermination d'une distance non nulle entre les dipôles émetteurs et l'électrode réflectrice, pour laquelle une durée de vie des dipôles émetteurs présentant l'orientation choisie est supérieure à celle des dipôles émetteurs présentant l'orientation non choisie, à partir d'une fonction prédéterminée exprimant une évolution d'un paramètre représentatif de la durée de vie d'un dipôle émetteur présentant l'une ou l'autre desdites orientations en fonction de sa distance à l'électrode réflectrice, compte tenu des propriétés optiques desdits matériaux choisi ;
- réalisation de la diode électroluminescente, une épaisseur de la première couche semiconductrice étant telle que les dipôles émetteurs sont situés à la distance déterminée vis-à-vis de l'électrode réflectrice, et une épaisseur de la deuxième couche semiconductrice étant telle que les dipôles émetteurs sont situés à la distance déterminée vis-à-vis dudit troisième milieu.

Certains aspects préférés mais non limitatifs de ce procédé sont les suivants.

L'étape de détermination peut comporter les étapes suivantes :

- détermination, sur une gamme de distance prédéfinie, de l'évolution en fonction de la distance du paramètre représentatif de la durée de vie du dipôle émetteur présentant l'orientation choisie, et de l'évolution en fonction de la distance du paramètre représentatif de la durée de vie du dipôle émetteur présentant l'orientation non choisie ;
- détermination d'un paramètre dit d'écart représentatif d'un écart du paramètre représentatif de la durée de vie du dipôle émetteur présentant l'orientation choisie vis-à-vis du paramètre représentatif de la durée de vie du dipôle émetteur présentant l'orientation non choisie, sur ladite gamme de distance prédéfinie ;
- détermination de ladite distance de sorte que :
  o le paramètre représentatif de la durée de vie du dipôle émetteur présentant l'orientation choisie est supérieur, pour la distance déterminée, à celui du paramètre représentatif de la durée de vie du dipôle émetteur présentant l'orientation non choisie, et que :
  o le paramètre d'écart présente, pour la distance déterminée, une valeur maximale sur au moins une partie de la gamme de distance.

La distance déterminée peut être définie suivant un axe orthogonal au plan de la couche active, et est définie entre d'une part l'interface entre l'électrode réflectrice et la première couche semiconductrice et d'autre part un plan passant par la moitié d'une épaisseur de la couche active.

La couche active peut comporter au moins une couche émissive de puits quantique, et une couche barrière située entre la première couche semiconductrice et la couche émissive, la distance déterminée étant définie suivant un axe orthogonal au plan de la couche active, entre d'une part l'interface entre l'électrode réflectrice et la première couche semiconductrice et d'autre part un plan passant par la moitié de l'épaisseur de la couche émissive.

L'électrode réflectrice peut s'étendre de manière parallèle au plan de la couche active.

L'électrode réflectrice peut être une anode adaptée à injecter des trous dans l'empilement semiconducteur.

La première couche semiconductrice peut être réalisée en un matériau cristallin semiconducteur dopé de type P, ou peut être réalisée en un matériau semiconducteur organique conducteur de trous.

La deuxième couche semiconductrice peut être revêtue d'une couche dite d'extraction comportant des particules nanométriques choisies parmi des boîtes quantiques ou des particules métalliques.

Les particules nanométriques peuvent être des particules métalliques, auquel cas l'orientation choisie est de préférence une orientation verticale.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1, déjà décrite, est une vue en coupe, schématique et partielle, d'une diode électroluminescente selon un exemple de l'art antérieur ;

la figure 2, déjà décrite, illustre schématiquement un dipôle émetteur $\mu$ dans un premier milieu homogène et situé à une distance h d'un deuxième milieu homogène, émettant un rayonnement lumineux correspondant à une recombinaison radiative d'une paire électron-trou ;

la figure 3 est une vue en coupe, schématique et partielle, d'une diode électroluminescente obtenue selon un procédé de fabrication selon un mode de réalisation, illustrant un dipôle émetteur situé dans une couche active et disposé à une distance h d'une électrode réflectrice ;

la figure 4A illustre un exemple d'évolutions en fonction de la distance h, de la durée de vie normalisée $\tau_{n,v}$ d'un dipôle émetteur $\mu$ d'orientation verticale et celle $\tau_{n,h}$ d'un dipôle émetteur $\mu$ d'orientation horizontale, dans le cas où le premier milieu homogène est réalisé à base de GaN, et où le deuxième milieu homogène (électrode P) est réalisé en argent, pour une longueur d'onde d'émission égale à 460nm ;

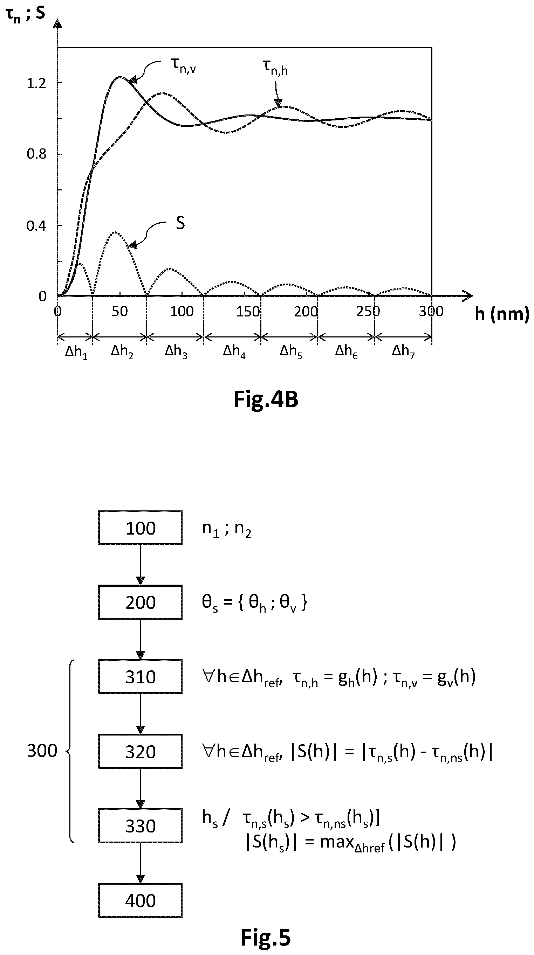

la figure 4B illustre un autre exemple d'évolutions en fonction de la distance h, de la durée de vie normalisée $\tau_{n,v}$ d'un dipôle émetteur $\mu$ d'orientation verticale et celle $\tau_{n,h}$ d'un dipôle émetteur $\mu$ d'orientation horizontale, dans le cas où le premier milieu homogène est réalisé à base de GaN, et où le deuxième milieu homogène est réalisé en or, pour une longueur d'onde d'émission égale à 460nm, et illustre également l'évolution en fonction de la distance h d'un paramètre appelé sélectivité S représentatif d'un écart entre ces deux durées de vie normalisées $\tau_{n,v}$, $\tau_{n,h}$ ;

la figure 5 illustre un organigramme de différentes étapes d'un procédé de fabrication d'une diode électroluminescente selon un mode de réalisation ;

la figure 6 est une vue en coupe, schématique et partielle, d'une diode électroluminescente obtenue selon un procédé de fabrication selon un mode de réalisation, comportant une couche d'extraction comportant des nanoparticules métalliques.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'au moins une diode électroluminescente présentant un rendement lumineux amélioré. Le rendement lumineux est défini ici comme le rapport du flux lumineux émis par la diode électroluminescente sur la puissance électrique injectée, et correspond à l'efficacité quantique externe (EQE). Il est égal au produit du rendement quantique interne (IQE) et de l'efficacité d'extraction lumineuse. Le rendement quantique interne est le rapport du nombre de photons générés par recombinaison radiative sur le nombre d'électrons injectés par la cathode, et l'efficacité d'extraction lumineuse est le rapport du nombre de photons émis hors de la diode sur le nombre de photons générés.

Pour cela, comme explicité en détail par la suite, on dimensionne au moins l'une des couches semiconductrices de la diode électroluminescente de sorte que les dipôles émetteurs associés aux recombinaisons radiatives des paires électron-trou dans la couche active présentent une orientation prédéfinie, laquelle est choisie entre deux orientations prédéfinies orthogonales entre elles, i.e. une orientation horizontale et une orientation verticale. Le caractère horizontal ou vertical de l'orientation du dipôle émetteur est relatif à un plan suivant lequel s'étend la couche active de la diode électroluminescente. Par ailleurs, l'orientation d'un dipôle émetteur correspond à l'angle d'inclinaison $\theta$ que forme le moment dipolaire $\mu$ du dipôle émetteur vis-à-vis d'un axe orthogonal au plan de la couche active.

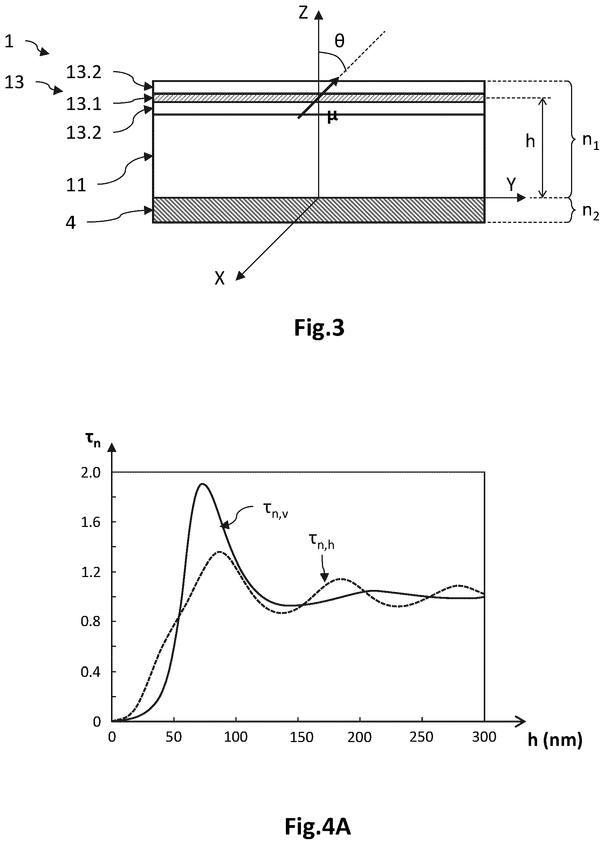

La figure 3 est une vue en coupe, schématique et partielle, d'un exemple de diode électroluminescente 1. Cette diode électroluminescente 1 est similaire à celle décrite précédemment, et est ici obtenue par un procédé de fabrication selon un mode de réalisation.

On définit ici et pour la suite de la description un repère direct orthogonal XYZ, où les axes X et Y forment un plan parallèle au plan principal d'un substrat (non représenté) sur lequel repose la diode électroluminescente 1, et où l'axe Z est orienté de manière orthogonale au plan XY. Ici, la couche active 13 s'étend suivant le plan XY, tout comme l'électrode réflectrice 4.

La diode électroluminescente 1 comporte ainsi un empilement semiconducteur formé d'une première couche 11, d'une couche active 13, et d'une deuxième couche 12 (cf. fig.1). Dans cet exemple, l'empilement semiconducteur est réalisé à base d'un matériau semiconducteur cristallin inorganique, mais en variante, il peut être réalisé à base d'un matériau semiconducteur organique (OLED). La diode électroluminescente 1 peut comporter des couches supplémentaires non représentées, par exemple une couche de blocage d'électrons, une couche tampon d'adaptation du paramètre de maille, etc...

Par réalisé à base de matériau semiconducteur, on entend que l'empilement semiconducteur est réalisé en ce matériau semiconducteur ou en un ou plusieurs composés comportant ce matériau semiconducteur. A titre d'exemple, l'empilement semiconducteur est réalisé à base d'un composé III-V, par exemple à base de GaN, et peut ainsi comporter au moins une couche semiconductrice en GaN dopé ou non, et au moins une couche semiconductrice en un composé comportant du GaN, par exemple en InGaN, AIGaN, InAIGaN, voire est réalisée à base d'InP, par exemple du type AlInGaP.

Notons comme indiqué précédemment que la diode électroluminescente 1 peut être une diode organique, auquel cas elle est formée de deux électrodes anodique et cathodique entre lesquelles sont empilées des couches semiconductrices organiques, dont une couche de transport d'électrons (ETL), une couche active (EML) et une couche de transport de trous (HTL).

Dans cet exemple où la diode électroluminescente 1 est réalisée à base d'un matériau inorganique, l'empilement semiconducteur est réalisé à base de GaN, la première couche 11 est en GaN dopé P, la deuxième couche 12 est en GaN dopé N. La couche active 13 comporte ici une couche 13.1 de puits quantique en InGaN intrinsèque située entre deux couches barrières 13.2 en GaN intrinsèque. Bien entendu, la couche active 13 peut comporter plusieurs couches de puits quantique situées entre deux couches barrières. L'électrode réflectrice 4 est réalisée en un ou plusieurs matériaux métalliques choisis parmi l'argent, l'aluminium, le cuivre, le titane, l'or, le nickel, l'iridium, le tungstène, l'indium, entre autres. Elle s'étend au contact de la première couche 11. Elle est dite réflectrice dans la mesure où son coefficient de réflexion est au moins égal à 75%, au moins égal à 85%, voire à 95%, voire encore davantage, à la longueur d'onde d'émission de la diode électroluminescente 1. La couche active 13 s'étend suivant un plan XY parallèle à celui de l'électrode réflectrice 4.

La couche active 13 étant le lieu principal de la recombinaison radiative des paires électron-trou, les dipôles émetteurs sont situés dans la couche active 13, et sont donc espacés d'une distance h vis-à-vis de l'électrode réflectrice 4. On considère qu'ils sont situés dans un plan espacé de la distance h non nulle de l'électrode réflectrice 4. On note h=0 l'interface entre l'électrode réflectrice 4 et la première couche 11.

La distance h séparant les dipôles émetteurs de l'électrode réflectrice 4 est définie pour la suite de la description comme étant la distance suivant l'axe Z entre un plan passant par la moitié de l'épaisseur de la couche active 13 et l'électrode réflectrice 4. Cependant, en variante, et notamment lorsque la couche active 13 comporte plusieurs couches émissives 13.1 de puits quantique, on peut définir la distance h comme étant la distance suivant l'axe Z entre d'une part un plan passant par la moitié de l'épaisseur de la première couche 13.1 de puits quantique et d'autre part l'électrode réflectrice 4. Une étude préalable peut être effectuée pour déterminée où se situe précisément dans la couche active 13 l'essentiel des recombinaisons radiatives des paires électron-trou.

Dans cet exemple, la distance h est donc égale à la somme de l'épaisseur de la première couche 11, de l'épaisseur de la couche barrière 13.2, et de la moitié de l'épaisseur de la couche émissive 13.1.

L'orientation d'un dipôle émetteur correspond à l'angle $\theta$ entre le moment dipolaire $\mu$ du dipôle émetteur et l'axe Z orthogonal au plan XY de la couche active 13. Aussi, un angle $\theta$ égal à 0° correspond à une orientation verticale des dipôles émetteurs vis-à-vis du plan de la couche active 13, et un angle $\theta$ égal à 90° correspond à une orientation horizontale.

On considère par ailleurs que les dipôles émetteurs sont situés dans un premier milieu optiquement linéaire, homogène, et isotrope, de constante diélectrique $\varepsilon_1$ (permittivité relative) et d'indice de réfraction $n_1$, ce premier milieu homogène étant formé de la couche active 13 et de la première couche 11. Par optiquement homogène, on entend que la constante diélectrique $\varepsilon_1$ est sensiblement constante en tout point de ce premier milieu homogène, à 10% près, voire à 5% près, voire moins. L'électrode réflectrice 4 forme un deuxième milieu optiquement linéaire, homogène et isotrope, de constante diélectrique $\varepsilon_2$ et d'indice de réfraction $n_2$.

Le procédé de fabrication d'une diode électroluminescente 1 comporte une phase de détermination d'une distance notée $h_s$ non nulle entre les dipôles émetteurs associés aux recombinaisons radiatives dans la couche active 13 et l'électrode réflectrice 4, de sorte que les dipôles émetteurs présentent une orientation choisie parmi l'orientation horizontale ($\theta$=90°) et l'orientation verticale ($\theta$=0°). L'épaisseur de la première couche 11 peut ensuite être déterminée en tenant compte de la valeur $h_s$.

Pour cela, une fonction g est prédéterminée qui exprime une évolution, en fonction de la distance h, d'un paramètre représentatif d'une durée de vie d'un dipôle émetteur présentant l'une ou l'autre desdites orientations, en fonction des propriétés optiques $n_1$, $n_2$ des premier et deuxième milieux homogènes. Ainsi, la fonction g est notée $g_h$ ou $g_v$ lorsqu'elle est relative à une orientation horizontale ($\theta$=90°) ou verticale ($\theta$=0°). Et elle est notée $g_s$ ou $g_{ns}$ lorsqu'elle est relative à l'orientation choisie ou à l'orientation non choisie.

La durée de vie $\tau$ est définie comme étant celle d'un dipôle émetteur situé dans un milieu optiquement homogène de constante diélectrique $\varepsilon$. Elle correspond à la durée de vie de l'émission spontanée d'un système à deux niveaux, dont on considère en première approximation qu'elle est identique à la durée de vie des dipôles émetteurs dans le cadre de l'électroluminescence. On note $\tau_n$ la durée de vie normalisée égale au rapport de la durée de vie $\tau/\tau_0$, où la durée de vie $\tau_0$ est définie comme étant celle d'un dipôle émetteur situé dans le même milieu mais de dimensions infinies, donc à une distance infinie du deuxième milieu homogène.

Or, la durée de vie normalisée $\tau_n$ est égale à l'inverse de la puissance rayonnée normalisée P/Po du dipôle émetteur, autrement dit : $\tau_n = \tau/\tau_0 = Po/P$. Ici, P est le taux de dissipation d'énergie du dipôle émetteur, autrement dit la puissance optique rayonnée par le dipôle émetteur dans le premier milieu homogène et situé à une distance h du deuxième milieu homogène, et Po est la puissance optique rayonnée par le même dipôle émetteur dans le premier milieu homogène de dimensions infinies (i.e. loin du deuxième milieu homogène, par exemple à plus de 500nm de celui-ci).

L'ouvrage de Novotny & Hecht intitulé Principles of Nano-Optics, Cambridge University Press, 2006, indique en page 344 (équation n°10.26) une expression de la puissance optique rayonnée normalisée $P/P_0$ d'un dipôle émetteur situé dans un premier milieu homogène à une distance h d'un substrat formé d'un deuxième milieu homogène (couche mince) et d'un troisième milieu homogène.

Cette équation peut être adaptée à notre configuration d'une diode électroluminescente 1 où le dipôle émetteur est situé dans le premier milieu homogène formé de la couche active 13 et de la première couche 11 et disposé à une distance h du deuxième milieu homogène formé de l'électrode réflectrice 4. Ainsi, la puissance optique rayonnée normalisée par un tel dipôle émetteur peut s'écrire :

$$\frac{P}{P_0} = 1 + \frac{3}{4}\frac{\mu_x^2 + \mu_y^2}{\mu^2}\int_0^{\infty} Re\left(\frac{s}{s_z}[r^s - s_z^2 r^p]e^{2ik_1hs_z}\right)ds + \frac{3}{2}\frac{\mu_z^2}{\mu^2}\int_0^{\infty} Re\left(\frac{s^3}{s_z}r^p e^{2ik_1hs_z}\right)ds$$

où :

- $\mu$ est la norme du moment dipolaire, et $\mu_{x,y,z}$ est la coordonnée cartésienne du moment dipolaire suivant l'axe x, y ou z ;
- s est la variable d'intégration définie par $s = k_p/k_1$, avec :

  o $k_p$ la projection du vecteur d'onde k dans le plan XY, de sorte que $k_p = k_x/cos\Phi$ et $k_p = k_y/sin\Phi$ ; et $k_1$ est la norme du vecteur d'onde k dans le milieu 1 ;
  o sz égal à $(1-s^2)^{1/2}$ ;

- $r^s$ et $r^p$ sont les coefficients de réflexion du rayonnement optique émis par le dipôle émetteur pour les polarisations s et p à l'interface entre la première couche 11 et l'électrode réflectrice 4. Ces coefficients dépendent de la variable d'intégration s et leurs expressions générales sont données par les équations 10.20 et 10.21 en p.342 de Novotny & Hecht 2006.

Cependant, dans la configuration selon l'invention, le coefficient de réflexion $r^p$ à l'interface avec l'électrode réflectrice 4 pour le rayonnement lumineux de polarisation p peut s'écrire, en fonction de la variable d'intégration s, de la manière suivante :

$$r^p = \frac{\tan\left[\tan^{-1}\left(\frac{s}{s_z}\right) - \sin^{-1}\left(\frac{n_1}{n_2}\sin\left(\tan^{-1}\left(\frac{s}{s_z}\right)\right)\right)\right]}{\tan\left[\tan^{-1}\left(\frac{s}{s_z}\right) + \sin^{-1}\left(\frac{n_1}{n_2}\sin\left(\tan^{-1}\left(\frac{s}{s_z}\right)\right)\right)\right]}$$

Et le coefficient de réflexion $r^s$ à l'interface avec l'électrode réflectrice 4 pour le rayonnement lumineux de polarisation s peut s'écrire, en fonction de la variable d'intégration s, de la manière suivante :

$$r^s = -\frac{\sin\left[\tan^{-1}\left(\frac{s}{s_z}\right) - \sin^{-1}\left(\frac{n_1}{n_2}\sin\left(\tan^{-1}\left(\frac{s}{s_z}\right)\right)\right)\right]}{\sin\left[\tan^{-1}\left(\frac{s}{s_z}\right) + \sin^{-1}\left(\frac{n_1}{n_2}\sin\left(\tan^{-1}\left(\frac{s}{s_z}\right)\right)\right)\right]}$$

Par ailleurs, le terme $\mu_z^2/\mu^2$ correspond à $cos\theta$, et le terme $(\mu_x^2 + \mu_y^2)/\mu^2$ est égal à $sin\theta$. Le vecteur d'onde k présente, dans le premier milieu homogène, une norme notée $k_1$ égale à $2\pi/(n_1 \times \lambda)$. Comme mentionné précédemment, $n_1$ et $n_2$ sont les indices de réfraction des premier et deuxième milieux homogènes, lesquels sont déduits des constantes diélectriques $\varepsilon_1$, $\varepsilon_2$.

Ainsi, la puissance rayonnée P par le dipôle émetteur est formée de trois termes principaux, à savoir la puissance rayonnée intrinsèque Po (loin de tout phénomène associé à l'environnement du premier milieu homogène), un terme correspondant à la puissance rayonnée associée au moment dipolaire $\mu_x$ et $\mu_y$ dans le plan XY et un terme correspondant à la puissance rayonnée associée au moment dipolaire $\mu_z$ suivant l'axe Z.

Cette équation est obtenue à partir des équations de Maxwell, en utilisant les fonctions dyadiques de Green pour décrire un unique dipôle ponctuel oscillant, et la méthode de spectre angulaire du champ du dipôle vient étendre les fonctions de Green en ondes planes et évanescentes respectivement dans un système cylindrique. Le dipôle émetteur interagit donc avec ses propres ondes planes et évanescentes réfléchies.

Ainsi, on obtient une fonction g exprimant l'évolution d'un paramètre représentatif de la durée de vie d'un dipôle émetteur d'orientation θ prédéfinie en fonction de la distance h à l'électrode réflectrice 4, compte tenu des propriétés optiques $n_1$ du premier milieu homogène (première couche 11 et couche active 13) et de celles $n_2$ du deuxième milieu homogène (électrode réflectrice 4). Le paramètre représentatif est de préférence la durée de vie normalisée $\tau_n = \tau/\tau_0$.

La figure 4A illustre un exemple d'évolutions, en fonction de la distance h, de la durée de vie normalisée $\tau_{n,v}$ d'un dipôle émetteur d'orientation verticale et celle $\tau_{n,h}$ d'un dipôle émetteur d'orientation horizontale, dans le cas où le premier milieu homogène est réalisé à base de GaN, et où le deuxième milieu homogène est réalisé en argent, pour une longueur d'onde d'émission égale à 460nm. Ces évolutions sont déterminées à partir de la fonction g décrite précédemment, et sont données sur une gamme de distance $\Delta h_{ref}$ prédéfinie allant de 0nm à 300nm.

Plus précisément, la diode électroluminescente 1 comporte une couche émissive en InGaN (pas de couche barrière en GaN intrinsèque) et une première couche 11 en GaN dopé P qui forment ensemble le premier milieu homogène. L'indice de réfraction $n_1$ est égal à 2.4764 environ pour une longueur d'onde d'émission de $\lambda=460$nm. La première couche 11 est au contact d'une électrode réflectrice 4 réalisée en argent qui forme le deuxième milieu homogène et présentent un indice de réfraction $n_2$ égal à la racine carrée de sa constante diélectrique $\varepsilon_2$ égale à $-7.5666+i\times0.24451$.

Il apparaît que les durées de vie normalisées $\tau_{n,v}$, $\tau_{n,h}$ sont nulles lorsque la distance h est nulle, puis augmentent jusqu'à un premier pic, et varient ensuite à mesure que la distance h augmente en présentant des oscillations amorties autour de valeurs constantes sensiblement égales.

Dans la mesure où les évolutions des durées de vie normalisées $\tau_{n,v}$, $\tau_{n,h}$ en fonction de la distance h ne sont pas en phase l'une avec l'autre et tendent vers une même valeur constante pour h grand, il apparaît que la durée de vie associée à l'une des orientations prédomine sur la durée de vie associée à l'autre orientation pour plusieurs domaines $\Delta h_i = 1, 2...$ de distance h de la gamme $\Delta h_{ref}$, et que cette prédominance alterne en fonction de la distance h.

Aussi, il est possible de déterminer une distance $h_s$ pour laquelle la durée de vie normalisée $\tau_{n,s}$ associée à l'orientation choisie des dipôles émetteurs est supérieure à la durée de vie normalisée $\tau_{n,ns}$ associée à l'autre orientation non choisie. Dans ce cas, les dipôles émetteurs présentant l'orientation choisie seront prépondérants sur ceux présentant l'orientation non choisie. La diode électroluminescente 1 peut alors être dimensionnée, en particulier l'épaisseur de la première couche 11, de sorte que les dipôles émetteurs soient situés à la distance $h_s$ de l'électrode réflectrice 4.

La figure 4B illustre un autre exemple d'évolutions, en fonction de la distance h, de la durée de vie normalisée $\tau_{n,v}$ d'un dipôle émetteur d'orientation verticale et celle $\tau_{n,h}$ d'un dipôle émetteur d'orientation horizontale, dans le cas où le premier milieu homogène est réalisé à base de GaN, et où le deuxième milieu homogène est réalisé en or, pour une longueur d'onde d'émission égale à 460nm. Elle illustre également l'évolution, en fonction de la distance h, d'un paramètre S appelé sélectivité représentatif d'un écart entre ces deux durées de vie normalisées $\tau_{n,v}$, $\tau_{n,h}$.

Dans cet exemple, le premier milieu homogène d'indice de réfraction $n_1$ est formé de la première couche 11 en GaN dopé P et d'une couche émissive en InGaN (pas de couche barrière en GaN intrinsèque). Le deuxième milieu homogène d'indice de réfraction $n_2$ est formée par l'électrode réflectrice 4 réalisée ici en or. La longueur d'onde d'émission est égale à 460nm.

Comme précédemment, la durée de vie normalisée $\tau_n$ des dipôles émetteurs présentant une orientation horizontale ou verticale augmente à partir d'une valeur nulle pour h égal à zéro jusqu'à un premier pic, puis tend vers une même valeur constante en présentant des oscillations amorties. Les valeurs constantes sont sensiblement égales pour les deux orientations. Cependant, les oscillations n'étant pas en phase l'une avec l'autre, il existe des domaines $\Delta h_i = 1, 2...$ de la gamme $\Delta h_{ref}$ pour lesquels la durée de vie normalisée associée à l'une des orientations est prépondérante sur la durée de vie normalisée associée à l'autre orientation. Il est alors possible de dimensionner la diode électroluminescente 1, en particulier de choisir une valeur $h_s$ de la distance, de sorte que les dipôles émetteurs présentent l'orientation choisie de manière prépondérante sur l'orientation non choisie.

Dans cet exemple, les dipôles émetteurs d'orientation verticale sont prépondérants dans les domaines $\Delta h_2$, $\Delta h_4$, $\Delta h_6$ de la gamme $\Delta h_{ref}$ allant de zéro à 300nm. Et les dipôles émetteurs d'orientation horizontale sont prépondérants dans les domaines $\Delta h_1$, $\Delta h_3$, $\Delta h_5$, $\Delta h_7$. Ainsi, dimensionner la diode électroluminescente 1 pour que la distance $h_s$ soit comprise dans le domaine $\Delta h_1$, ou $\Delta h_3$, par exemple, permettra d'obtenir des recombinaisons radiatives des paires électron-trou dont le rayonnement émis correspond à celui de dipôles émetteurs présentant une orientation essentiellement horizontale. En revanche, une distance $h_s$ comprise dans le domaine $\Delta h_2$ ou $\Delta h_4$, par exemple, permettra d'obtenir des recombinaisons radiatives des paires électron-trou dont le rayonnement émis correspond à celui de dipôles émetteurs présentant une orientation essentiellement verticale.

Comme mentionné précédemment, pour obtenir une prépondérance des dipôles émetteurs ayant l'orientation choisie sur ceux ayant l'orientation non choisie, il importe que la durée de vie des dipôles émetteurs ayant l'orientation choisie soit supérieure à celle des dipôles émetteurs ayant l'autre orientation.

Il est alors avantageux que la distance $h_s$ soit déterminée de sorte qu'un écart entre les durées de vie normalisées des dipôles émetteurs d'orientation horizontale et verticale soit maximal en valeur absolue.

Aussi, on peut définir un paramètre dit d'écart S, appelé sélectivité, représentatif d'un écart entre la durée de vie normalisée $\tau_{n,s}$ d'un dipôle émetteur ayant l'orientation choisie et la durée de vie normalisée $\tau_{n,ns}$ d'un dipôle émetteur ayant l'orientation non choisie. Cette sélectivité S peut être définie comme étant la différence ou le rapport, en valeur absolue ou non, entre la durée de vie normalisée $\tau_{n,s}$ d'un dipôle émetteur présentant l'orientation choisie et la durée de vie normalisée $\tau_{n,ns}$ d'un dipôle émetteur présentant l'orientation non choisie. Autrement dit, $S = \tau_{n,s} - \tau_{n,ns}$ ou en variante $S = \tau_{n,s} / \tau_{n,ns}$. Par la suite, on utilise $S = \tau_{n,s} - \tau_{n,ns}$.

La figure 4B illustre également l'évolution en fonction de la distance h de la valeur absolue $| S |$ de la sélectivité S. Celle-ci s'annule ainsi entre chaque domaine $\Delta h_i$ et présente une valeur maximale pour chacune d'entre elles. A titre d'exemple, la sélectivité présente une valeur de 0.18 pour 18nm dans $\Delta h_1$ (orientation horizontale), une valeur de 0.36 pour 46nm dans $\Delta h_2$ (orientation verticale), une valeur de 0.15 pour 90nm dans $\Delta h_3$ (orientation horizontale), et une valeur de 0.08 pour 140nm dans $\Delta h_4$ (orientation verticale). Il apparaît donc que les différents domaines ne présentent pas une sélectivité S de même intensité, signe que les durées de vie normalisées évoluent en fonction de la distance h sous forme d'oscillations amorties.

Ainsi, pour améliorer le rendement lumineux d'une diode électroluminescente 1, il est possible de dimensionner celle-ci de sorte que les dipôles émetteurs présentent une orientation prédéfinie, par exemple horizontale. Pour cela, la distance $h_s$ est choisie dans l'un des domaines $\Delta h_i$ de la gamme $\Delta h_{ref}$ pour lesquelles la durée de vie des dipôles émetteurs ayant l'orientation prédéfinie est supérieure à celle des dipôles émetteurs ayant l'autre orientation. De plus, la distance $h_s$ est avantageusement déterminée de sorte que la sélectivité S présente un maximum dans la gamme de distance $\Delta h_{ref}$ déterminée. Dans cet exemple, pour obtenir une prédominance des dipôles émetteurs d'orientation horizontale, il est avantageux que la distance $h_s$ soit égale à 18nm dans la mesure où la sélectivité S présente un maximum égal à 0.18.

La figure 5 est un organigramme illustrant des étapes d'un procédé de fabrication d'une diode électroluminescente 1 selon un mode de réalisation. Le procédé de fabrication est ici illustré dans le cas d'une diode électroluminescente 1 comportant un empilement semiconducteur de type inorganique. Dans cet exemple, la première couche 11 est réalisée en GaN dopé P, et une couche active 13 est formée d'une couche émissive de puits quantique en InGaN. L'électrode réflectrice 4 est réalisée en argent.

Dans une étape 100, on choisit les matériaux de la première couche 11 et de la couche active 13 qui forment ensemble le premier milieu homogène d'indice de réfraction $n_1$. Il s'agit ici d'un GaN dopé P et d'InGaN, dont l'indice de réfraction est sensiblement égal pour ces deux matériaux et correspond à 2.4764 à la longueur d'onde d'émission de 460nm. Dans le cas où les indices de réfraction ne sont pas identiques, on peut définir un indice de réfraction moyen à partir par exemple d'une pondération volumique des indices de réfraction. On choisit également le matériau de l'électrode réflectrice 4 qui forme le deuxième milieu homogène d'indice de réfraction $n_2$ (obtenu à partir de la constante diélectrique $\varepsilon_2$). Dans le cas de l'argent, l'indice de réfraction $n_2$ est égal à $0.044439+ix2.7511$.

Comme indiqué précédemment, la distance h correspond ici à la distance suivant l'axe Z entre l'interface électrode réflectrice 4 / première couche 11 et la moitié de l'épaisseur de la couche active 13. Dans cet exemple, la couche active 13 est une couche émissive 13.1 de puits quantique de 3nm d'épaisseur, et on cherche à déterminer l'épaisseur de la première couche 11 de sorte que les dipôles émetteurs (situés en première approximation au centre de la couche active 13) soient situés à la distance $h_s$ déterminée pour obtenir l'orientation dipolaire choisie.

Dans une étape 200, on choisit l'orientation souhaitée $\theta_s$ des dipôles émetteurs associés aux recombinaisons radiatives des paires électron-trou dans la couche active 13, c'est-à-dire ici l'angle $\theta$ que forme le moment dipolaire $\mu$ vis-à-vis de l'axe Z orthogonal au plan de la couche active 13, parmi l'orientation verticale $\theta_v$ ($\theta=0°$) et l'orientation horizontale $\theta_h$ ($\theta=90°$). Dans cet exemple, l'orientation choisie $\theta_s$ est l'orientation horizontale $\theta_h$ ($\theta_s=90°$).

Dans une étape 300, on détermine une valeur $h_s$ de la distance h de sorte qu'une durée de vie des dipôles émetteurs ayant l'orientation choisie $\theta_s$ soit supérieure à celle des dipôles émetteurs ayant l'orientation non choisie $\theta_{ns}$. On utilise pour cela la fonction prédéterminée g exprimant une relation entre une durée de vie d'un dipôle émetteur ayant une orientation prédéfinie $\theta$ et la distance h. Cette fonction g est celle décrite précédemment, qui exprime l'évolution de la durée de vie normalisée $\tau_n$ d'un dipôle émetteur en fonction de la distance h, par le biais de la puissance optique rayonnée normalisée P/Po.

Ainsi, dans une sous-étape 310, on détermine l'évolution $g_h$ en fonction de h de la durée de vie normalisée

$\tau_{n,h}$ d'un dipôle émetteur d'orientation horizontale $\theta_h$, ainsi que l'évolution $g_v$ de la durée de vie normalisée $\tau_{n,v}$ d'un dipôle émetteur d'orientation verticale $\theta_v$, sur une gamme de distance $\Delta h_{ref}$ allant par exemple de Onm à 300nm. Ces évolutions $g_h$ et $g_v$ sont déterminées à partir des relations $\tau_n$ = Po/P et P/Po= f(h) indiquées précédemment. On obtient ainsi $\tau_{n,v}$ = $g_v$(h) et $\tau_{n,h}$ = $g_h$(h) pour h quelconque compris dans la gamme $\Delta h_{ref}$.

Dans une sous-étape 320, on compare la durée de vie du dipôle émetteur d'orientation choisie $\tau_{n,h}$ à la durée de vie du dipôle émetteur d'orientation non choisie $\tau_{n,v}$ pour tout h compris dans $\Delta h_{ref}$. On détermine avantageusement le paramètre de sélectivité S telle que, pour tout h compris dans $\Delta h_{ref}$, la valeur absolue | S | de la sélectivité S est égale à la valeur absolue de la différence entre la durée de vie $\tau_{n,s}$ du dipôle émetteur d'orientation choisie et la durée de vie $\tau_{n,ns}$ du dipôle émetteur d'orientation non choisie, c'est-à-dire ici : |S(h)| = | $\tau_{n,h}$(h) - $\tau_{n,v}$(h) |.

Dans une sous-étape 330, on détermine alors une valeur $h_s$ telle que la durée de vie $\tau_{n,s}$ du dipôle émetteur d'orientation choisie $\theta_s$ est supérieure à la durée de vie $\tau_{n,ns}$ du dipôle émetteur d'orientation non choisie θns, c'est-à-dire ici de sorte que $\tau_{n,h}$(hs) > $\tau_{n,v}$(hs). De plus, la valeur $h_s$ est avantageusement déterminée de sorte que la sélectivité | S(h$_s$) | est maximale sur au moins un domaine de la gamme $\Delta h_{ref}$, et de préférence sur toute la gamme $\Delta h_{ref}$, autrement dit | S(h$_s$) | = max$_{\Delta href}$( | S(h) | ).

D'autres conditions peuvent être également prises en compte, comme par exemple le fait que la valeur h$_s$ soit supérieure ou égale à une valeur minimale h$_{th}$ non nulle prédéfinie, par exemple pour optimiser la diffusion des porteurs de charge dans le plan XY au sein de la première couche 11 à partir de l'électrode réflectrice 4.

Dans une étape 400, on fabrique la diode électroluminescente 1 de sorte que les dipôles émetteurs soient situés à la distance h$_s$ de l'électrode réflectrice 4. Dans le cas où la couche active 13 présente des dimensions fixées, par exemple 3nm pour une couche de puits quantique et 12nm pour une couche barrière, on détermine l'épaisseur de la première couche 11 de sorte que la somme de cette épaisseur et de la moitié de la couche active 13 soit égale à la valeur déterminée h$_s$, par exemple à 10nm près, voire à 5nm près.

Aussi, les dipôles émetteurs associés aux recombinaisons radiatives des paires électron-trou dans la couche active 13 présentent essentiellement l'orientation choisie $\theta_s$, par exemple ici l'orientation horizontale. On améliore ainsi le rendement lumineux de la diode électroluminescente 1.

Par ailleurs, le procédé de fabrication peut comporter une phase de dimensionnement de la deuxième couche 12 disposée entre la couche active 13 et une deuxième électrode (cathode). La deuxième couche 12 et la couche active 13 forme le même premier milieu homogène d'indice de réfraction n$_1$. Cette phase de dimensionnement est ici identique ou similaire à celle décrite précédemment, et n'est pas détaillée à nouveau. Dans ce cas, un troisième milieu optiquement linéaire, homogène et isotrope, d'indice de réfraction n$_3$, peut être la cathode, laquelle peut être transparente à la longueur d'onde d'émission, ou un milieu diélectrique (air, gaz) environnant la diode électroluminescente 1. On améliore ainsi davantage le rendement lumineux de la diode électroluminescente 1.

Plus précisément, on détermine une distance h'$_s$ non nulle entre les dipôles émetteurs et le troisième milieu homogène de sorte que la durée de vie ($\tau_{n,s}$) des dipôles émetteurs présentant l'orientation choisie est supérieure à celle des dipôles émetteurs présentant l'orientation non choisie ($\tau_{n,ns}$), et de préférence que la sélectivité associée soit maximale. On réalise ensuite la diode électroluminescente 1, de sorte que l'épaisseur de la deuxième couche 12 est telle que les dipôles émetteurs sont situés à la distance déterminée h'$_s$ vis-à-vis dudit troisième milieu homogène.

Par ailleurs, comme mentionné précédemment, il est avantageux que l'orientation choisie $\theta_s$ des dipôles émetteurs soit l'orientation horizontale $\theta_h$ ($\theta$=90°) lorsque l'extraction lumineuse hors de la diode électroluminescente 1 n'induit pas un couplage en champ proche de type dipôle-dipôle avec des boîtes quantiques ou des particules plasmoniques situées sur la face d'émission de la diode électroluminescente 1. En effet, il est reconnu que le rendement lumineux est augmenté lorsque les dipôles émetteurs présentent l'orientation horizontale $\theta_h$ ($\theta$=90°).

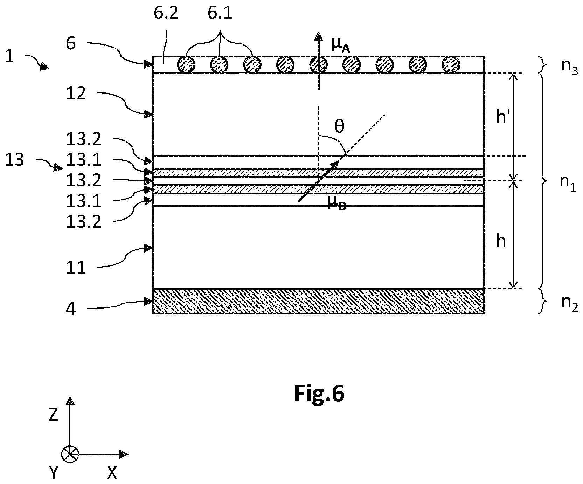

En revanche, lorsque l'extraction lumineuse induit un couplage en champ proche de type dipôle-dipôle, il est avantageux que l'orientation choisie des dipôles émetteurs soit une orientation verticale $\theta_v$ ($\theta$=0°). A ce titre, la figure 6 est une vue en coupe, schématique et partielle, d'une diode électroluminescente 1 dont la face d'extraction est formée par une couche 6 comportant des particules nanométriques 6.1 métalliques ou des boîtes quantiques. Par champ proche, on entend que la distance entre les dipôles accepteurs et donneurs est inférieure ou égale à $\lambda$/5, voire inférieure ou égale à $\lambda$/10, où $\lambda$ est la longueur d'onde d'émission du rayonnement émis par la couche active, moyennant l'indice de réfraction du milieu, dans laquelle le champ électrique rayonné par le dipôle décroît en 1/r$^3$.

Les particules nanométriques 6.1 présentent un diamètre moyen de l'ordre de quelques nanomètres à quelques centaines de nanomètres, par exemple sont comprises entre 0.2nm et 500nm, et de préférence entre 2nm et 150nm. Elles peuvent notamment être des particules métalliques et/ou des boîtes quantiques. Les particules sont des éléments distincts les uns des autres, dont la forme peut être quelconque, par exemple sphérique, anguleuse, aplatie ou allongée, ou toute autre forme. La taille des particules est ici la plus petite dimension des particules et le diamètre moyen est la moyenne arithmétique de la taille des particules.

Dans cet exemple, la diode électroluminescente 1 comporte une électrode réflectrice 4, une première couche semiconductrice 11, une couche active 13 formée ici de deux couches 13.1 de puits quantiques disposées entre des couches barrières 13.2, une deuxième couche semiconductrice 12, et une couche d'extraction 6. La couche d'extraction 6 comporte ici des particules métalliques 6.1 de taille nanométrique disposée de préférence dans un matériau diélectrique transparent 6.2.

Les particules nanométriques 6.1 sont réalisées en un matériau métallique, celui-ci pouvant être choisi parmi Ag, Cu, Au, Pt, Pd, Ni, Co, Rh, In, Ru, Fe, CuNi, entre autres, et parmi les composés formés d'un mélange d'au moins deux ou plus de ces matériaux. La densité surfacique de particules métalliques 6.1 est déterminée par la théorie de Mie de manière à optimiser l'efficacité d'absorption d'une particule métallique 6.1 en fonction de l'indice de réfraction du milieu diélectrique. A titre d'exemple, pour un milieu diélectrique d'indice de réfraction de 1.5, un diamètre moyen de 55nm pour des particules nanométriques d'argent permet d'optimiser l'efficacité d'absorption à 460nm. La section efficace d'absorption de ces particules est alors de $0.5 \times 10^{-14} m^2$ et la densité surfacique peut alors être de l'ordre de $2 \times 10^{14} m^{-2}$. Le matériau diélectrique transparent 6.2 présente un coefficient de transmission du rayonnement incident au moins égal à 50%, de préférence au moins égal à 75%, voire à 90%, voire davantage. Il peut être choisi parmi le silicone, le polysiloxane, les PDMS, le PMMA, le PVA, les couches minérales à base d'oxyde de type sol-gel tel que le $SiO_2$, $Al_2O_3$, ZnO, $TiO_2$, entre autres.

De plus, un couplage dipôle-dipôle en champ proche est présent entre les dipôles notés ici $\mu_D$, (pour Donneurs) associés aux recombinaisons radiatives dans la couche active 13 et les dipôles notés ici $\mu_A$ (pour Accepteurs) associés à l'émission plasmonique. Ces dipôles $\mu_A$ et $\mu_D$, sont les vecteurs des moments dipolaires. L'intensité de ce couplage est caractérisée par le facteur angulaire de couplage $K^2$.

De manière connue, le facteur angulaire de couplage $K^2$ entre les dipôles émetteurs $\mu_A$ et $\mu_D$, est défini par la relation :

$$K^2 = \left(\boldsymbol{n_A}.\boldsymbol{n_D} - 3(\boldsymbol{n_A}.\boldsymbol{n_D})(\boldsymbol{n_r}.\boldsymbol{n_A})\right)^2$$

Cette expression est notamment décrite dans l'ouvrage de Novotny & Hecht 2006 en page 290 (équation 8.169). Le facteur $K^2$ dépend de l'orientation des vecteurs unitaires $n_A$ et $n_D$ associés aux dipôles accepteurs et donneurs, et du vecteur unitaire $n_r$ reliant les dipôles donneurs et accepteurs considérés.

Ici, le mode résonnant plasmonique des particules métalliques 6.1 correspond à des dipôles accepteurs situés en champ proche des dipôles donneurs. L'interaction dipôle-dipôle modifie les propriétés d'absorption des dipôles accepteurs. Il y a un transfert d'énergie non-radiatif entre les dipôles donneurs et les dipôles accepteurs, appelé couplage FRET *(Förster resonance energy transfer,* en anglais), qui se traduit par une augmentation du rendement lumineux de la diode électroluminescente 1.

Il apparaît que le facteur angulaire de couplage $K^2$ est maximal lorsque les dipôles donneurs $\mu_D$, et accepteurs $\mu_A$ sont colinéaires, auquel cas, le facteur $K^2$ est égal à 4. Ainsi, dimensionner la première couche 11 et avantageusement la deuxième couche 12 pour obtenir une orientation prépondérante des dipôles donneurs $\mu_D$, qui soit verticale, permet de rendre colinéaires les dipôles donneurs et accepteurs, et ainsi d'améliorer encore le rendement lumineux de la diode électroluminescente 1.

En effet, dans le cas où la couche d'extraction 6 comporte des particules métalliques 6.1, le rendement lumineux de la diode électroluminescente 1 est augmenté de plus par une émission lumineuse supplémentaire par effet plasmonique. Les particules métalliques 6.1 peuvent ainsi émettre un rayonnement lumineux à une longueur d'onde de résonance sensiblement identique à la longueur d'onde d'électroluminescence $\lambda_e$ de la diode électroluminescente 1. Pour cela, des modes plasmoniques des particules métalliques 6.1 sont excités, dont un mode résonant peut conduire à l'émission du rayonnement lumineux supplémentaire. Ici, le mode résonant plasmonique des particules métalliques 6.1 correspond à des dipôles accepteurs $\mu_A$ situés en champ proche des dipôles donneurs $\mu_D$,.

Dans le cas où les particules nanométriques 6.1 sont des boîtes quantiques, celles-ci peuvent être réalisées sous la forme de nanocristaux semiconducteurs, dont la taille moyenne peut être comprise entre 0.2nm et 500nm, par exemple entre 1nm et 100nm, et notamment entre 2nm et 30nm. Le matériau semiconducteur des nanocristaux peut être notamment choisi parmi le séléniure de cadmium (CdSe), le phosphore d'indium (InP), le sulfure de cadmium (CdS), le sulfure de zinc (ZnS), l'oxyde de cadmium (CdO), le séléniure de zinc et de cadmium (CdZnSe), ou parmi d'autres matériaux semiconducteurs pouvant convenir. La densité surfacique dépend ici notamment du taux de conversion de lumière désiré, c'est-à-dire du rapport entre l'intensité du rayonnement de photoluminescence émis par les boîtes quantiques 6.1 sur l'intensité du rayonnement d'électroluminescence émis par la couche active 13. La couche d'extraction 6 assure alors une fonction supplémentaire de conversion de couleur, en convertissant une partie du rayonnement lumineux émis par la couche active 13 en un rayonnement lumineux de plus grande longueur d'onde.

Les particules nanométriques 6.1 peuvent également être des boîtes quantiques à effet plasmon, réalisées par exemple d'un cœur métallique entouré d'une gaine diélectrique, elle-même entourée d'une couche formant une boîte quantique. Le cœur métallique, par exemple en argent, forme une antenne absorbante pour le couplage dipôle-dipôle, et couple cette énergie absorbée au matériau formant la boîte quantique, qui va ensuite émettre un rayonnement de photoluminescence.

Des modes de réalisation particuliers viennent d'être décrits. Différentes variantes et modifications apparaîtront à l'homme du métier. La portée de l'invention est définie par les revendications.

**Revendications**

1. Procédé de fabrication d'au moins une diode électroluminescente (1) comportant un empilement formé d'une première couche semiconductrice (11), d'une deuxième couche semiconductrice (12), et d'une couche active (13) située entre les deux couches semiconductrices, une électrode réflectrice (4) s'étendant au contact de la première couche semiconductrice (11), le procédé comportant les étapes suivantes :

   o choix (100) des matériaux de la première couche semiconductrice (11) et de la couche active (13), et de l'électrode réflectrice (4) ;
   o choix (200) d'une orientation ($\theta_s$), vis-à-vis d'un plan de la couche active (13), des dipôles dits émetteurs associés aux recombinaisons radiatives de paires électron-trou dans la couche active (13), parmi :

      • une orientation horizontale ($\theta_h$) pour laquelle les dipôles émetteurs sont orientés de manière parallèle au plan de la couche active (13), et
      • une orientation verticale ($\theta_v$) pour laquelle les dipôles émetteurs sont orientés de manière orthogonale au plan de la couche active (13) ;

   o détermination (300) d'une distance ($h_s$) non nulle entre les dipôles émetteurs et l'électrode réflectrice (4), pour laquelle une durée de vie ($\tau_{n,s}$) des dipôles émetteurs présentant l'orientation choisie est supérieure à celle des dipôles émetteurs présentant l'orientation non choisie ($\tau_{n,ns}$),

      • à partir d'une fonction prédéterminée ($g_{h,v}$) exprimant une évolution d'un paramètre représentatif de la durée de vie d'un dipôle émetteur présentant l'une ou l'autre desdites orientations ($\theta_h$ ; $\theta_v$) en fonction de sa distance (h) à l'électrode réflectrice (4), compte tenu des propriétés optiques ($n_1$, $n_2$) desdits matériaux choisis ;

   o choix des matériaux de la deuxième couche semiconductrice (12), et d'un troisième milieu (6) recouvrant la deuxième couche semiconductrice (12) ;
   o détermination d'une distance ($h'_s$) non nulle entre les dipôles émetteurs et ledit troisième milieu, pour laquelle une durée de vie ($\tau_{n,s}$) des dipôles émetteurs présentant l'orientation choisie est supérieure à celle des dipôles émetteurs présentant l'orientation non choisie ($\tau_{n,ns}$),

      • à partir d'une fonction prédéterminée ($g_{h,v}$) exprimant une évolution d'un paramètre représentatif de la durée de vie d'un dipôle émetteur présentant l'une ou l'autre desdites orientations ($\theta_h$ ; $\theta_v$) en fonction de sa distance (h) audit troisième milieu, compte tenu des propriétés optiques (ni, $n_3$) desdits matériaux choisis ;

   o réalisation (400) de la diode électroluminescente (1), une épaisseur de la première couche semiconductrice (11) étant telle que les dipôles émetteurs sont situés à la distance déterminée ($h_s$) vis-à-vis de l'électrode réflectrice (4), et une épaisseur de la deuxième couche semiconductrice (12) étant telle que les dipôles émetteurs sont situés à la distance déterminée ($h'_s$) vis-à-vis dudit troisième milieu.

2. Procédé selon la revendication 1, dans lequel l'étape de détermination (300) comporte les sous-étapes suivantes :

   • détermination (310), sur une gamme de distance ($\Delta h_{ref}$) prédéfinie, de l'évolution en fonction de la distance (h) du paramètre ($\tau_{n,s}$) représentatif de la durée de vie du dipôle émetteur présentant l'orientation choisie ($\theta_s$), et de l'évolution en fonction de la distance (h) du paramètre ($\tau_{n,ns}$) représentatif de la durée de vie du dipôle émetteur présentant l'orientation non choisie ($\theta_{ns}$) ;
   • détermination (320) d'un paramètre dit d'écart (S) représentatif d'un écart du paramètre ($\tau_{n,s}$) représentatif de la durée de vie du dipôle émetteur présentant l'orientation choisie ($\theta_s$) vis-à-vis du paramètre ($\tau_{n,ns}$) représentatif de la durée de vie du dipôle émetteur présentant l'orientation non choisie ($\theta_{ns}$), sur ladite gamme de distance ($\Delta href$) prédéfinie ;
   • détermination (330) de ladite distance ($h_s$) de sorte que :

      - le paramètre ($\tau_{n,s}$) représentatif de la durée de vie du dipôle émetteur présentant l'orientation choisie ($\theta_s$)

est supérieur, pour la distance déterminée (hs), à celui du paramètre ($\tau_{n,ns}$) représentatif de la durée de vie du dipôle émetteur présentant l'orientation non choisie ($\theta_{ns}$), et que

- le paramètre d'écart (S) présente, pour la distance déterminée ($h_s$), une valeur maximale sur au moins une partie de la gamme de distance ($Ah_{ref}$).

3. Procédé selon la revendication 1 ou 2, dans lequel la distance déterminée ($h_s$) est définie suivant un axe orthogonal au plan de la couche active (13), entre d'une part l'interface entre l'électrode réflectrice (4) et la première couche semiconductrice (11) et d'autre part un plan passant par la moitié d'une épaisseur de la couche active (13).

4. Procédé selon l'une quelconque des revendications 1 à 3, dans lequel la couche active (13) comporte au moins une couche émissive (13.1) de puits quantique, et une couche barrière (13.2) située entre la première couche semiconductrice (11) et la couche émissive (13.1), la distance déterminée ($h_s$) étant définie suivant un axe orthogonal au plan de la couche active (13), entre d'une part l'interface entre l'électrode réflectrice (4) et la première couche semiconductrice (11) et d'autre part un plan passant par la moitié de l'épaisseur de la couche émissive (13.1).

5. Procédé selon l'une quelconque des revendications 1 à 4, dans lequel l'électrode réflectrice (4) s'étend de manière parallèle au plan de la couche active (13).

6. Procédé selon l'une quelconque des revendications 1 à 5, dans lequel l'électrode réflectrice (4) est une anode adaptée à injecter des trous dans l'empilement semiconducteur.

7. Procédé selon l'une quelconque des revendications 1 à 6, dans lequel la première couche semiconductrice (11) est réalisée en un matériau cristallin semiconducteur dopé de type P, ou est réalisée en un matériau semiconducteur organique conducteur de trous.

8. Procédé selon l'une quelconque des revendications 1 à 7, dans lequel la deuxième couche semiconductrice (12) est revêtue d'une couche dite d'extraction (6) comportant des particules nanométriques (6.1) choisies parmi des boîtes quantiques ou des particules métalliques.

9. Procédé selon la revendication 8, dans lequel les particules nanométriques (6.1) sont des particules métalliques, et dans lequel l'orientation choisie est une orientation verticale.

**Patentansprüche**

1. Verfahren zur Herstellung mindestens einer Leuchtdiode (1), die einen Stapel umfasst, der aus einer ersten halbleitenden Schicht (11), einer zweiten halbleitenden Schicht (12) und einer zwischen den beiden halbleitenden Schichten gelegenen aktiven Schicht (13) gebildet ist, wobei sich eine reflektierende Elektrode (4) im Kontakt mit der ersten halbleitenden Schicht (11) erstreckt, wobei das Verfahren die folgenden Schritte umfasst:

   o Wählen (100) der Materialien der ersten halbleitenden Schicht (11) und der aktiven Schicht (13) und der reflektierenden Elektrode (4);
   o Wählen (200) einer Ausrichtung ($\theta_s$), gegenüber einer Ebene der aktiven Schicht (13), der sogenannten Emitterdipole, die den strahlenden Rekombinationen von Elektron-Loch-Paaren in der aktiven Schicht (13) zugeordnet sind, unter:

      • einer horizontalen Ausrichtung ($\theta_h$), bei der die Emitterdipole parallel zur Ebene der aktiven Schicht (13) ausgerichtet sind, und
      • einer vertikalen Ausrichtung ($\theta_v$), bei der die Emitterdipole senkrecht zur Ebene der aktiven Schicht (13) ausgerichtet sind;

   o Bestimmen (300) eines Abstands ($h_s$) ungleich null zwischen den Emitterdipolen und der reflektierenden Elektrode (4), bei dem eine Lebensdauer ($_{Tn,s}$) der Emitterdipole, die die gewählte Ausrichtung aufweisen, größer ist als die der Emitterdipole, die die nicht gewählte Ausrichtung ($_{Tn,ns}$) aufweisen,

      • ausgehend von einer vorbestimmten Funktion ($g_{h,v}$), die einen Verlauf Parameters ausdrückt, der für die Lebensdauer eines Emitterdipols repräsentativ ist, der die eine oder die andere der Ausrichtungen ($\theta_h$; $\theta_v$) aufweist, in Abhängigkeit von seinem Abstand (h) zu der reflektierenden Elektrode (4), unter Berücksich-

tigung der optischen Eigenschaften ($n_1$, $n_2$) der gewählten Materialien;

o Wählen der Materialien der zweiten halbleitenden Schicht (12) und eines dritten Milieus (6), das die zweite halbleitende Schicht (12) bedeckt;

o Bestimmen eines Abstands ($h'_s$) ungleich null zwischen den Emitterdipolen und dem dritten Milieu, bei dem eine Lebensdauer ($_{Tn'_s}$) der Emitterdipole, die die gewählte Ausrichtung aufweisen, größer ist als die der Emitterdipole, die die nicht gewählte Ausrichtung ($_{Tn'_{ns}}$) aufweisen,

• ausgehend von einer vorbestimmten Funktion ($g_{h,v}$), die einen Verlauf eines Parameters ausdrückt, der für die Lebensdauer eines Emitterdipols repräsentativ ist, der die eine oder die andere der Ausrichtungen ($\theta_h$; $\theta_v$) aufweist, in Abhängigkeit von seinem Abstand ($h$) zu dem dritten Milieu, unter Berücksichtigung der optischen Eigenschaften ($n_1$, $n_3$) der gewählten Materialien;

o Ausführen (400) der Leuchtdiode (1), wobei eine Dicke der ersten halbleitenden Schicht (11) derart ist, dass die Emitterdipole in dem bestimmten Abstand ($h_s$) gegenüber der reflektierenden Elektrode (4) gelegen sind, und wobei eine Dicke der zweiten halbleitenden Schicht (12) derart ist, dass die Emitterdipole in dem bestimmten Abstand ($h'_s$) gegenüber dem dritten Milieu gelegen sind.

2. Verfahren nach Anspruch 1, bei dem der Schritt des Bestimmens (300) die folgenden Teilschritte umfasst:

• Bestimmen (310), über einen vorgegebenen Abstandsbereich ($\Delta h_{ref}$), des Verlaufs in Abhängigkeit von dem Abstand ($h$) des Parameters ($_{Tn'_s}$), der für die Lebensdauer des Emitterdipols repräsentativ ist, der die gewählte Ausrichtung ($\theta_s$) aufweist, und des Verlaufs in Abhängigkeit von dem Abstand ($h$) des Parameters ($_{Tn'_{ns}}$), der für die Lebensdauer des Emitterdipols repräsentativ ist, der die nicht gewählte Ausrichtung ($\theta$ns) aufweist;
• Bestimmen (320) eines sogenannten Abweichungsparameters (S), der für eine Abweichung des Parameters ($_{Tn'_s}$) repräsentativ ist, der für die Lebensdauer des Emitterdipols repräsentativ ist, der die gewählte Ausrichtung ($\theta_s$) aufweist, gegenüber dem Parameter ($_{Tn'_{ns}}$), der für die Lebensdauer des Emitterdipols repräsentativ ist, der die nicht gewählte Ausrichtung ($\theta$ns) aufweist, über den vorgegebenen Abstandsbereich ($\Delta h_{ref}$);
• Bestimmen (330) des Abstands ($h_s$) derart, dass:

- der Parameter ($_{Tn'_s}$), der für die Lebensdauer des Emitterdipols repräsentativ ist, der die gewählte Ausrichtung ($\theta_s$) aufweist, größer ist, für den bestimmten Abstand ($h_s$), als der des Parameters ($_{Tn'_{ns}}$), der für die Lebensdauer des Emitterdipols repräsentativ ist, der die nicht gewählte Ausrichtung ($\theta$ns) aufweist, und dass

- der Abweichungsparamater (S), für den bestimmten Abstand ($h_s$), einen Maximalwert über mindestens einen Teil des Abstandsbereichs ($\Delta h_{ref}$) aufweist.

3. Verfahren nach Anspruch 1 oder 2, bei dem der bestimmte Abstand ($h_s$) entlang einer Achse senkrecht zur Ebene der aktiven Schicht (13) zwischen einerseits der Grenzfläche zwischen der reflektierenden Elektrode (4) und der ersten halbleitenden Schicht (11) und andererseits einer Ebene, die durch die Hälfte einer Dicke der aktiven Schicht (13) verläuft, definiert wird.

4. Verfahren nach einem der Ansprüche 1 bis 3, bei dem die aktive Schicht (13) mindestens eine emissive Quantentopfschicht (13.1) und eine zwischen der ersten halbleitenden Schicht (11) und der emissiven Schicht (13.1) gelegene Barriereschicht (13.2) umfasst, wobei der bestimmte Abstand ($h_s$) entlang einer Achse senkrecht zur Ebene der aktiven Schicht (13) zwischen einerseits der Grenzfläche zwischen der reflektierenden Elektrode (4) und der ersten halbleitenden Schicht (11) und andererseits einer Ebene, die durch die Hälfte der Dicke der emissiven Schicht (13.1) verläuft, definiert wird.

5. Verfahren nach einem der Ansprüche 1 bis 4, bei dem sich die reflektierende Elektrode (4) parallel zur Ebene der aktiven Schicht (13) erstreckt.

6. Verfahren nach einem der Ansprüche 1 bis 5, bei dem die reflektierende Elektrode (4) eine Anode ist, die dazu angepasst ist, Löcher in den halbleitenden Stapel zu injizieren.

7. Verfahren nach einem der Ansprüche 1 bis 6, bei dem die erste halbleitende Schicht (11) aus einem P-dotierten halbleitenden kristallinen Material ausgeführt ist oder aus einem lochleitenden organischen halbleitenden Material ausgeführt ist.

**8.** Verfahren nach einem der Ansprüche 1 bis 7, bei dem die zweite halbleitende Schicht (12) mit einer sogenannten Extraktionsschicht (6) überzogen ist, die nanometrische Partikel (6.1) umfasst, die unter Quantenpunkten oder Metallpartikeln gewählt sind.

**9.** Verfahren nach Anspruch 8, bei dem die nanometrischen Partikel (6.1) Metallpartikel sind und bei dem die gewählte Ausrichtung eine vertikale Ausrichtung ist.

**Claims**

**1.** A method for producing at least one light-emitting diode (1) comprising a stack formed of a first semiconductor layer (11), of a second semiconductor layer (12), and of an active layer (13) located between the two semiconductor layers, a reflective electrode (4) extending in contact with the first semiconductor layer (11), the method comprising the following steps:

> o Choosing (100) the materials of the first semiconductor layer (11) and of the active layer (13), and of the reflective electrode (4);
> o choosing (200) an orientation ($\theta_s$), with respect to a plane of the active layer (13), of the emitting dipoles that are associated with the radiative recombination of electron-hole pairs in the active layer (13), from among:
>
>> • a horizontal orientation ($\theta_h$) for which the emitting dipoles are oriented so as to be parallel to the plane of the active layer (13), and
>> • a vertical orientation ($\theta_v$) for which the emitting dipoles are oriented so as to be orthogonal to the plane of the active layer (13);
>
> o determining (300) a non-zero distance ($h_s$) between the emitting dipoles and the reflective electrode (4), for which a lifetime ($\tau_{n,s}$) of the emitting dipoles having the chosen orientation is longer than that of the emitting dipoles having the non-chosen orientation ($\tau_{n,ns}$),
>
>> • on the basis of a predetermined function ($g_{h,v}$) expressing a change in a parameter representative of the lifetime of an emitting dipole having either of said orientations ($\theta_h$; $\theta_v$) according to its distance (h) from the reflective electrode (4), taking into account the optical properties ($n_i$, $n_2$) of said materials chosen;
>
> o choosing the materials of the second semiconductor layer (12), and of a third medium (6) covering the second semiconductor layer (12);
> o determining a non-zero distance ($h'_s$) between the emitting dipoles and said third medium, for which a lifetime ($\tau_{n,s}$) of the emitting dipoles having the chosen orientation is longer than that of the emitting dipoles having the non-chosen orientation ($\tau_{n,ns}$),
>
>> • on the basis of a predetermined function ($g_{h,v}$) expressing a change in a parameter representative of the lifetime of an emitting dipole having either of said orientations ($\theta_h$; $\theta_v$) according to its distance (h) from said third medium, taking into account the optical properties ($n_i$, $n_3$) of said materials chosen;
>
> o producing (400) the light-emitting diode (1), a thickness of the first semiconductor layer (11) being such that the emitting dipoles are located at the determined distance ($h_s$) with respect to the reflective electrode (4), and a thickness of the second semiconductor layer (12) being such that the emitting dipoles are located at the determined distance ($h'_s$) with respect to said third medium.

**2.** The method as claimed in claim 1, wherein the determining step (300) comprises the following sub-steps:

> • determining (310), over a predefined distance range ($\Delta h_{ref}$), the change according to the distance (h) in the parameter ($\tau_{n,s}$) representative of the lifetime of the emitting dipole having the chosen orientation ($\theta_s$), and the change according to the distance (h) in the parameter ($\tau_{n,ns}$) representative of the lifetime of the emitting dipole having the non-chosen orientation ($\theta_{ns}$);
> • determining (320) a difference parameter (S) representative of a difference in the parameter ($\tau_{n,s}$) representative of the lifetime of the emitting dipole having the chosen orientation ($\theta_s$) with respect to the parameter ($\tau_{n,ns}$) representative of the lifetime of the emitting dipole having the non-chosen orientation ($\theta_{ns}$), over said predefined distance range ($\Delta h_{ref}$);

• determining (330) said distance ($h_s$) such that:

- the parameter ($\tau_{n,s}$) representative of the lifetime of the emitting dipole having the chosen orientation ($\theta_s$) is greater, for the determined distance ($h_s$), than that of the parameter ($\tau_{n,ns}$) representative of the lifetime of the emitting dipole having the non-chosen orientation ($\theta_{ns}$), and that
- the difference parameter (S) has, for the determined distance ($h_s$), a maximum value over at least a portion of the distance range ($\Delta h_{ref}$).

3. The method as claimed in claim 1 or 2, wherein the determined distance ($h_s$) is defined along an axis orthogonal to the plane of the active layer (13), between, on the one hand, the interface between the reflective electrode (4) and the first semiconductor layer (11) and, on the other hand, a plane passing through halfway through the thickness of the active layer (13).

4. The method as claimed in anyone of claims 1 to 3, wherein the active layer (13) comprises at least one quantum well emissive layer (13.1), and a barrier layer (13.2) located between the first semiconductor layer (11) and the emissive layer (13.1), the determined distance ($h_s$) being defined along an axis orthogonal to the plane of the active layer (13), between, on the one hand, the interface between the reflective electrode (4) and the first semiconductor layer (11) and, on the other hand, a plane passing through halfway through the thickness of the emissive layer (13.1).

5. The method as claimed in any one of claims 1 to 4, wherein the reflective electrode (4) extends parallel to the plane of the active layer (13).

6. The method as claimed in any one of claims 1 to 5, wherein the reflective electrode (4) is an anode capable of injecting holes into the semiconductor stack.

7. The method as claimed in any one of claims 1 to 6, wherein the first semiconductor layer (11) is made of a P-doped semiconductor crystalline material, or made of a hole-conducting organic semiconductor material.

8. The method as claimed in any one of claims 1 to 7, wherein the second semiconductor layer (12) is coated with an extraction layer (6) comprising nanoscale particles (6.1) chosen from among quantum dots or metal particles.

9. The method as claimed in claim 8, wherein the nanoscale particles (6.1) are metal particles, and wherein the chosen orientation is a vertical orientation.

**Fig.1**

**Fig.2**

**Fig.3**

**Fig.4A**

**Fig.4B**

**Fig.5**

**Fig.6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1855327 A2
- US 2012153254 A1
- EP 2362448 A1
- US 2014008676 A1

**Littérature non-brevet citée dans la description**

- **SCHMIDT et al.** Emitter Orientation as a Key Parameter in Organic Light-Emitting Diodes. *Phys. Rev. Applied,* 2017, vol. 8, 037001
- **NOVOTNY ; HECHT.** Principles of Nano-Optics. Cambridge University Press, 2006
- *Novotny & Hecht,* 2006, 342